# EUROPÄISCHE PATENTSCHRIFT

(11) **EP 2 597 377 B1**
(45) Veröffentlichungstag und Bekanntmachung des Hinweises auf die Patenterteilung: **13.09.2017**
(21) Anmeldenummer: 12193306.3
(22) Anmeldetag: 20.11.2012
(51) Int. Cl.: F24C 7/08, D06F 39/00, G05G 1/08, H01H 25/00, H03K 17/97, G05G 1/10

(54) **Bedieneinrichtung für ein Haushaltsgerät sowie Haushaltsgerät zum Zubereiten von Lebensmitteln mit einer derartigen Bedieneinrichtung**
Operating device for a household device and household device for preparing food with such an operating device
Dispositif d'utilisation pour un appareil ménager et appareil ménager destiné à la préparation d'aliments avec un tel dispositif d'utilisation

(30) Priorität: 28.11.2011 DE 102011087218
(43) Veröffentlichungstag der Anmeldung: 29.05.2013
(73) Patentinhaber: BSH Hausgeräte GmbH, 81739 München (DE)
(72) Erfinder: Knöller, Thomas, 86356 Neusäß (DE); Schmidt, Tobias, 80636 München (DE)

(56) Entgegenhaltungen:
- EP-A1- 2 420 734
- EP-A2- 0 962 707
- EP-A2- 2 251 762
- WO-A1-2004/038298
- DE-A1-102006 034 391
- DE-A1-102009 000 388

## Beschreibung

Die Erfindung betrifft eine Bedieneinrichtung für ein Haushaltsgerät, mit einem abnehmbaren und gleitend bewegbaren Bedienelement, dessen Bewegbarkeit durch eine Begrenzungskontur eines Bewegungsbereichs begrenzt ist, und welches abhängig von einer Bewegung zur Einstellung von Betriebsbedingungen des Haushaltsgeräts ausgebildet ist. Darüber hinaus betrifft die Erfindung auch ein Haushaltsgerät mit einer derartigen Bedieneinrichtung, insbesondere ein Haushaltsgerät zur Zubereitung von Lebensmitteln.

Aus der DE 10 2008 017 779 A1 ist ein Kochfeld mit einem abnehmbaren gleitend bewegbaren Bedienelement bekannt. Dort ist vorgesehen, dass ein zylinderförmiges Bedienelement an seiner Unterseite einen kleinen nach unten ragenden Führungsstift aufweist. Der Führungsstift erstreckt sich in eine Vertiefung, die durch eine Begrenzungskontur begrenzt ist. Nur dieser Führungsstift ragt in die Vertiefung hinein. Das eigentliche zylinderförmige Bedienelement ist außerhalb der Vertiefung angeordnet und liegt mit seinem Boden, an dem auch der Führungsstift angeordnet ist, auf der Oberseite der Begrenzungskontur auf. Durch Bewegung des Bedienelements wird der Führungsstift in der Vertiefung entsprechend geführt und schlägt gegebenenfalls an der Begrenzungskontur an. Durch die Bewegung des Bedienelements können Einstellungen des Kochfelds durchgeführt werden. Der Durchmesser des Bedienelements ist wesentlich größer als ein maximaler Durchmesser der Vertiefung, sodass das Bedienelement im Normalbetrieb die Vertiefung vollständig überdeckt. Eine derartige Ausgestaltung ist relativ hochbauend und die genaue Bewegungsführung sowie die exakte Positionsfindung mit Nachteilen verbunden. Denn die eigentliche Führungsstruktur ist durch den kleinen Führungsstift gegeben, der doch in seinen Ausmaßen wesentlich kleiner ist als das Bedienelement selbst. Die von oben erkennbare Bewegung des Bedienelements wird dabei durch einen Nutzer anders wahrgenommen, als es tatsächlich durch den Führungsstift, der dann an die Begrenzungskontur anschlägt beziehungsweise daran entlang geführt wird, ist. Indem auch quasi die Begrenzungskontur nicht erkannt werden kann, ist die Bewegungsführung mit dem Bedienelement quasi durch einen Nutzer blind vollzogen.

Der nächstliegende Stand der Technik wird in dem Dokument DE 10 2009 000 388 A1 offenbart.

Die seitliche Beleuchtung eines Bedienmittels ist aus den Dokumenten DE 10 2006 034 391 A1 und EP 2 251 762 A2 bekannt. Es ist Aufgabe der vorliegenden Erfindung, eine Bedieneinrichtung zu schaffen, welche eine nutzerfreundlichere Bedienung ermöglicht. Insbesondere soll auch ein entsprechendes Haushaltsgerät mit einer Bedieneinrichtung geschaffen werden.

Diese Aufgabe wird durch eine Bedieneinrichtung und ein Haushaltsgerät, welche die Merkmale des unabhängigen Anspruchs aufweisen, gelöst. Eine erfindungsgemäße Bedieneinrichtung für ein Haushaltsgerät umfasst eine Bedienelementaufnahme, die eine Vertiefung aufweist. In diese Vertiefung ist ein Bedienelement positionierbar und auch wiederum aus der Vertiefung entnehmbar. Das Bedienelement ist relativ zur Bedienelementaufnahme im darin positionierten Zustand bewegbar, wobei diese Bewegung durch eine Begrenzungskontur der Vertiefung begrenzt ist. Abhängig von einer derartigen Relativbewegung ist eine Einstellung von Betriebsbedingungen des Haushaltsgeräts durchführbar. Die Begrenzungskontur der Vertiefung weist einen unebenen Boden auf, der mit einer kuppelartigen Erhebung ausgebildet ist. Der Boden ist somit zumindest bereichsweise mit einer sich nach oben erstreckenden Erhebung ausgebildet, auf welcher das Bedienelement zumindest bereichsweise aufsetzbar ist. Durch eine derartige Ausgestaltung des Bodens können ganz spezifische Bewegungsszenarien des Bedienelements in besonders vorteilhafter Weise realisiert werden. Indem einerseits das Bedienelement in der Vertiefung angeordnet und somit zumindest bereichsweise versenkt ist, kann ein unerwünschtes Verrutschen und somit mögliche Fehleinstellungen und grundsätzlich gar keine Einstellungen vermieden werden. Das Bedienelement kann somit nicht unerwünschterweise von der Bedienelementaufnahme herausfallen und somit diesbezüglich nicht beschädigt werden. Es kann somit nicht nur eine Verschiebung in einer Ebene, insbesondere in eine Horizontalebene erfolgen, sondern auch ein zumindest teilweises Schrägstellen des Bedienelements erreicht werden. Durch die unebene Ausgestaltung des Bodens mit einer kuppelartigen Erhebung kann diese Bewegung äußerst präzise und begrenzt erfolgen, sodass auch hier Fehleinstellungen vermieden werden. Darüber hinaus ist durch diese kuppelartige Erhebung des Bodens eine besonders leichtgängige und nutzerfreundliche als auch sichergeführte Bewegung in Richtung dieses geneigten Bodens möglich. Es ist vorgesehen, dass die Vertiefung mit einer horizontalen Breite ausgebildet ist, derart, dass das Bedienelement im in der Vertiefung positionierten Zustand mit horizontalem Spiel darin angeordnet ist. Dadurch kann auch eine Horizontalbewegung des Bedienelements ermöglicht werden, sodass auch diesbezüglich entsprechende Betriebsbedingungseinstellungen damit verknüpft sind. Durch diese multifunktionellen und ganz spezifischen Bewegungsmöglichkeiten des Bedienelements in dieser Vertiefung können multifunktionelle Einstellungen ermöglicht werden. Es ist aufgrund dieser Ausgestaltung somit auch möglich, dass das Bedienelement das einzige Element der Bedieneinrichtung zur Einstellung dieser Betriebsbedingungen ist. Dadurch kann auch eine sehr bedienelementreduzierte Ausgestaltung der Bedieneinrichtung geschaffen werden.

Vorzugsweise ist vorgesehen, dass die Vertiefung mit einer Begrenzungskontur so gestaltet ist, dass das Bedienelement in in der Vertiefung positionierten Zustand eine durch den Boden begrenzte Kippbewegung durchführen kann. Die oben genannten Vorteile gelten hier analog.

Vorzugsweise ist vorgesehen, dass die Unebenheit des Bodens in seinen Ausmaßen zumindest so groß wie die Ausmaße des Bodens des Bedienelements ausgebildet ist. Ein besonders leichtgängiges und sich nicht klemmendes oder sperrendes Schrägstellen des Bedienelements im Vergleich zur Horizontalebene ist dadurch ermöglicht.

Vorzugsweise ist vorgesehen, dass die kuppelartige Erhebung einen zentralen ebenen Flächenbereich aufweist, an den ein seitlich schräg nach außen abfallender Flächenbereich bzw. Flächenabschnitt anschließt. Die Ausgestaltung der kuppelartigen Erhebung kann somit vorzugsweise als Kegelstumpf realisiert sein. Durch eine derartige Ausgestaltung wird einerseits erreicht, dass das Bedienelement relativ stabil in seiner Grunstellung in der Vertiefung angeordnet ist und keine unerwünschten Kippbewegungen durchführt. Andererseits wird durch diese Gestaltung in besonders einfacher Weise mit entsprechend ausgebildeter Hebelwirkung eine einfache und leichtgängige Kippbewegung aus dieser Grundstellung heraus ermöglicht.

Vorzugsweise ist der zentrale Flächenbereich eine Kreisfläche. Die oben genannten Vorteile sind dadurch besonders gut erfüllt.

In einer alternativen Ausführung kann auch vorgesehen sein, dass die kuppelartige Erhebung stetig gekrümmt ausgebildet ist. Ein ebener Flächenbereich ist dann nicht vorgesehen.

Insbesondere bei einer derartigen Ausgestaltung, jedoch nicht auf diese beschränkt, ist vorteilhaft vorgesehen, dass ein Boden des Bedienelements uneben ausgebildet ist. Insbesondere ist vorgesehen, dass die Formgebung des Bodens komplementär zur kuppelartigen Erhebung ausgebildet bzw. daran angepasst ist. Ein besonders sattes Aufsitzen und gute Bewegungsführung ist dadurch erreicht.

Vorzugsweise ist vorgesehen, dass der gewölbte und somit unebene Boden des Bedienelements gegenüber der Wölbung weitere kleine Erhebungen, insbesondere Noppen, aufweist. Eine besonders leichtgängige Verschiebebewegung entlang der nach oben gewölbten bzw. stetig gekrümmten kuppelartigen Erhebung ist damit erreicht.

Abrupte Kippbewegungen können dadurch vermieden werden, sodass auch ein möglicher härterer Anschlag des Bodens des Bedienelements an dem Boden der Vertiefung verhindert werden kann.

Vorzugsweise ist vorgesehen, dass der Boden des Bedienelements vollflächig auf dem Boden der Vertiefung aufsitzt. Die eben genannten Vorteile sind dadurch besonders realisiert.

Vorzugsweise ist vorgesehen, dass das Bedienelement an seiner Oberseite eine in die gleiche Richtung ausgebildete Wölbung wie der Boden des Bedienelements aufweist. Im Querschnitt ergibt sich dann insbesondere ein am Boden und der Oberseite gleich geformtes Bedienelement, welches somit als sichelartiges Bauteil ausgebildet ist. Einerseits legt sich das Bedienelement dadurch sehr gut in eine Hand eines Nutzers, andererseits ist dadurch die Bewegungsführung leichtgängig und ruckfrei und zielgenau. Darüber hinaus kann es somit im Wesentlichen über die gesamte Breite mit gleicher Dicke ausgebildet werden, so dass es Gewicht sparend ausgebildet ist.

Ein kugelartiges Gleiten in der Bedienelementaufnahme ist dadurch möglich. Vorzugsweise ist eine Auswahl einer Funktionsteileinheit des Haushaltsgeräts, insbesondere einer Kochzone eines Kochfelds, durch Verschieben des Bedienelements aus seiner Grundstellung heraus erreicht, wobei dazu das Bedienelement nicht zwingend bis zum Kontakt mit der Begrenzungswand er Vertiefung geschoben werden muss. Es kann auch schon vorher eine Auswahl erkannt werden.

Durch die Haltemagnete und die Ausgestaltung der Bedienvorrichtung ist insbesondere auch erreicht, dass das Bedienelement von einem verschobenen Zustand automatisch wieder selbständig in die Grundstellung zurückführbar ist, was durch die magnetischen Kräfte bewirkt wird. Erfindungsgemäß ist vorgesehen, dass das Bedienelement einen Lichtaustrittsbereich aufweist, aus dem Licht in Richtung des Bodens der Vertiefung und/oder einer seitlichen Wand der Begrenzungskontur der Vertiefung emittierbar ist. Dadurch können ganz spezifische optische Anzeigen von Relativpositionen des Bedienelements zur Bedienelementaufnahme und somit auch von zugeordneten Betriebsbedingungseinstellungen für einen Nutzer leicht wahrnehmbar erfolgen. Indem das Licht nicht direkt nach oben abgestrahlt wird, kann auch ein unerwünschter Blendeffekt vermieden werden und insbesondere das direkte Hineinsehen in eine beispielsweise als Leuchtdiode ausgebildete Lichtquelle vermieden werden.

Vorzugsweise ist vorgesehen, dass der Boden der Vertiefung und somit auch der Begrenzungskontur zur Lichtreflexion in einen Freiraum zwischen dem Bedienelement und einer seitlichen Wand der Begrenzungskontur ausgebildet ist. Diesbezüglich kann somit auch ein ganz spezifisches Beleuchtungsszenario geschaffen werden, welches in ganz hervorzuhebender Weise Betriebsbedingungseinstellungen optisch erkennbar macht.

Vorzugsweise ist vorgesehen, dass eine bedienelementexterne Lichtquelle ausgebildet ist, deren Licht über den Boden der Vertiefung und über den Boden des Bedienelements in einen Lichtleiter des Bedienelements einkoppelbar ist.

Es kann vorgesehen sein, dass eine Lichtquelle zur Emission von Licht mit unterschiedlicher Lichtfarbe ausgebildet ist. Es kann auch vorgesehen sein, dass zumindest eine erste Lichtquelle ausgebildet ist, die zur Emission von Licht mit einer ersten Lichtfarbe ausgebildet ist und zumindest eine zweite Lichtquelle vorgesehen ist, welche zur Emission von Licht einer zur ersten unterschiedlichen zweiten Lichtfarbe ausgebildet ist. So kann beispielsweise vorgesehen sein, dass Licht der ersten Lichtfarbe dann emittiert wird, wenn sich das Bedienelement in seiner Grundstellung in der Bedienelementaufnahme befindet. Erfolgt dann eine Bewegung aus der Grundstellung heraus, so wird die Lichtfarbe gewechselt und Licht mit der zweiten Lichtfarbe emittiert. Beispielsweise kann das Licht mit der zweiten Lichtfarbe dann emittiert werden, wenn eine Auswahl einer Funktionsteileinheit des Haushaltsgeräts erfolgt ist und dies dann entsprechend dadurch optisch angezeigt wird. Es kann dann vorgesehen sein, dass das Licht mit der zweiten Lichtfarbe so lange emittiert wird, bis eine vorgebbare Zeitdauer nach der Auswahl der Funktionsteileinheit verstrichen ist und keine weitere Einstellung erfolgt ist oder bis eine Einstellung nach der Auswahl abgeschlossen ist, beispielsweise durch Einstellen eines Parameterwerts eines Betriebsparameters, beispielsweise einer Kochstufe einer Kochzone eines Kochfelds, der ausgewählten Funktionsteileinheit.

Vorzugsweise ist vorgesehen, dass die Vertiefung an der höchsten Stelle der Erhebung mit einer Tiefe ausgebildet ist, die zumindest der Hälfte, insbesondere zumindest zwei Drittel der Höhe des Bedienelements entspricht.

Des Weiteren betrifft die Erfindung ein Haushaltsgerät mit einer erfindungsgemäßen Bedieneinrichtung oder einer vorteilhaften Ausgestaltung davon. Insbesondere ist das Haushaltsgerät als Kochfeld ausgebildet, und es ist vorgesehen, dass die Bedienelementaufnahme der Bedieneinrichtung als Einsatz in eine Aussparung der Kochfeldplatte ausgebildet ist. Die Kochfeldplatte kann beispielsweise aus Glas oder Glaskeramik ausgestaltet sein.

Die Bedienelementaufnahme kann darüber hinaus auch einen Anzeigebereich aufweisen, auf dem Informationen als Bedruckung oder als optisch hinterleuchtbare Anzeigen ausgestaltet sind. Insbesondere kann somit unmittelbar benachbart zu der Vertiefung an der Oberseite der Bedienelementaufnahme zumindest ein derartiger Anzeigebereich ausgebildet sein. Insbesondere kann vorgesehen sein, dass mehrere Anzeigebereiche benachbart zu der Vertiefung zumindest bereichsweise um die Vertiefungen umlaufend ausgebildet sind. In diesem Zusammenhang können Informationen über einzelne Kochzonen des Kochfelds angezeigt werden, wie beispielsweise deren aktiver oder nicht aktiver Zustand und/oder eine eingestellte Kochstufe.

Vorzugsweise ist vorgesehen, dass entweder an dem ebenen zentralen Flächenbereich des Bodens der Vertiefung oder im Bereich der maximalen Höhe der Erhebung ein Haltemagnet angeordnet ist. Dieser kann in magnetischer Wechselwirkung mit einem im Bedienelement angeordneten Haltemagneten die magnetische Haltekraft erzeugen, mit welcher das Bedienelement in der Bedienelementaufnahme gehalten ist.

Im Hinblick auf die Lichtemission kann vorgesehen sein, dass beispielsweise mit der Auswahl einer Kochzone Licht in einer ersten Lichtfarbe von dem Bedienelement emittiert wird. Wird keinerlei Einstellung mit dem Bedienelement durchgeführt, so kann vorgesehene sein, dass Licht in einer zweiten Lichtfarbe emittiert wird.

Ein derartiger Farbwechsel des emittierten Lichts kann auch dann erfolgen, wenn für eine spezifische Zeitdauer nach der Einstellung einer Kochstufe keine weitere Einstellung erfolgt ist.

Vorzugsweise ist die Lichtquelle unterhalb der Bedienelementaufnahme angeordnet und emittiert Licht durch einen lichtdurchlässigen Bereich dieser Bedienelementaufnahme zum Bedienelement.

Indem Licht in Richtung des Bodens der Vertiefung von dem Boden des Bedienelements emittiert wird und dieser dann über den Boden nach oben und seitlich an dem Bedienelemente vorbei reflektiert wird, kann auch ein koronaartiger Lichteffekt innerhalb des Bauteils erzeugt werden.

Vorzugsweise ist vorgesehen, dass die Neigung des schräg abfallenden Flächenbereichs des unebenen Bodens gegenüber der Horizontalen in einem Winkel zwischen 10° und 25°, insbesondere zwischen 12° und 18°, vorzugsweise 15° abfällt.

Vorzugsweise weist der ebene zentrale Flächenbereich einen Durchmesser zwischen 7 mm und 15 mm, vorzugsweise zwischen 8 mm und 12 mm, linsbesondere 10 mm auf. Insbesondere kann vorgesehen sein, dass bei einer Ausgestaltung des Haushaltsgeräts als Kochfeld eine Kochzone durch eine Kippbewegung des Bedienelements in der Vertiefung in die jeweils vorgesehene Kipprichtung ausgewählt wird. Als optischer Hinweis, dass die Auswahl korrekt erfolgt ist, kann in einem Anzeigebereich, insbesondere auf der Oberseite der Bedienelementaufnahme dies optisch bestätigt werden.

Nach dem Loslassen des gekippten Bedienelements bewegt sich dieses aufgrund der Magnetwirkung der zentralen Haltemagnete selbständig wieder in seine horizontale Ausgangslage und somit in seine Grundstellung zurück. In dieser Grundstellung kann dann durch Drehen des Bedienelements um seine Längsachse entgegen oder in Richtung des Uhrzeigersinns die gewünschte Kochstufe eingestellt werden.

Weitere Merkmale der Erfindung ergeben sich aus den Ansprüchen, den Figuren und der Figurenbeschreibung. Die vorstehend in der Beschreibung genannten Merkmale und Merkmalskombinationen sowie die nur in den Figuren alleine und/oder in der Figurenbeschreibung alleine gezeigten Merkmale und Merkmalskombinationen sind nicht nur in der jeweils angegebenen Kombination, sondern auch in anderen Kombinationen oder in Alleinstellung verwendbar. Es können daher aus den jeweils offenbarten Merkmalen auch Kombinationen gebildet werden, die nicht explizit erläuterte Ausführungsbeispiele ergeben, die jedoch ebenfalls als offenbart anzusehen sind.

Ausführungsbeispiele werden nachfolgend anhand schematischer Zeichnungen näher erläutert. Es zeigen:
- Fig. 1: eine schematische perspektivische Darstellung eines Ausführungsbeispiels eines erfindungsgemäßen Haushaltsgeräts;
- Fig. 2: eine Schnittdarstellung durch ein erstes Ausführungsbeispiel einer nicht erfindungsgemäßen Bedieneinrichtung in einem als Kochfeld ausgebildeten Haushaltsgerät;
- Fig. 3: eine Schnittdarstellung durch ein Ausführungsbeispiel einer Bedieneinrichtung in einem als Haushaltsgerät ausgebildeten Kochfeld;
- Fig. 4: eine Schnittdarstellung durch ein drittes Ausführungsbeispiel einer nicht erfindungsgemäßen Bedieneinrichtung in einem als Haushaltsgerät ausgebildeten Kochfeld; und
- Fig. 5: ein Ausführungsbeispiel einer Bedieneinrichtung in einem als Haushaltsgerät ausgebildeten Kochfeld.

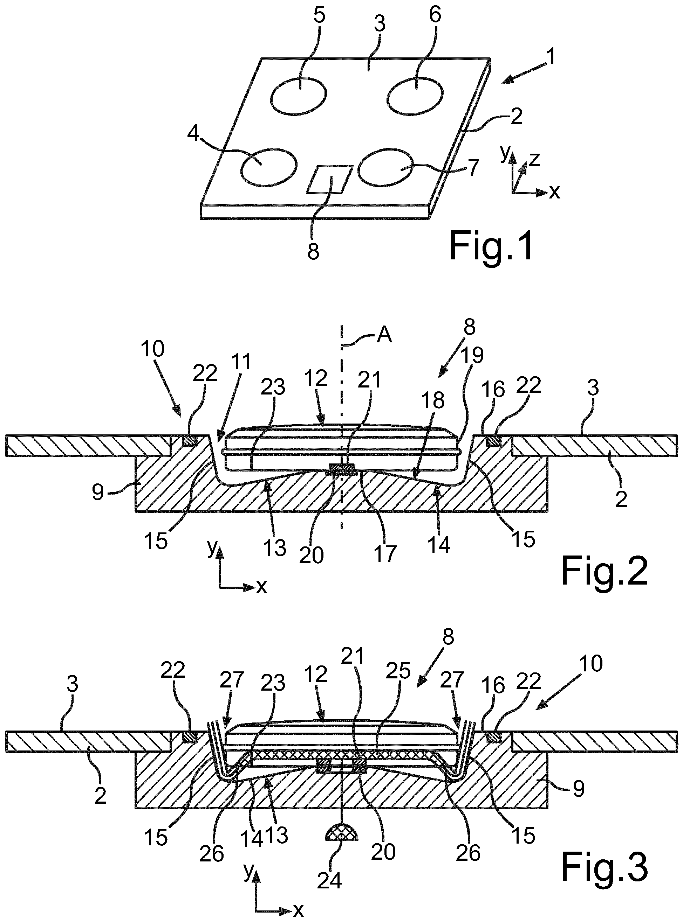

In Fig. 1 ist in einer schematischen Darstellung ein als Kochfeld 1 ausgebildetes Haushaltsgerät gezeigt. Dieses umfasst eine Kochfeldplatte, welche aus Glas oder Glaskeramik ausgebildet sein kann. Auf einer Oberseite 3 der Kochfeldplatte 2 sind in Position und Anzahl lediglich beispielhaft vier Kochzonen 4, 5, 6 und 7 ausgebildet. Diese kennzeichnen Flächen, auf denen Zubereitungsgefäße zum Erwärmen aufgestellt werden können. Unterhalb der Kochfeldplatte 2 sind im Bereich der Kochzonen 4 bis 7 nicht dargestellte Heizeinheiten angeordnet, mittels welchen das Heizen der Zubereitungsgefäße erfolgen kann.

Das Kochfeld 1 umfasst darüber hinaus eine Bedieneinrichtung 8, die im Weiteren näher erläutert wird.

Dazu ist in Fig. 2 eine Schnittdarstellung eines Ausführungsbeispiels einer Bedieneinrichtung 8 in der Schnittebene x-y in Fig. 1 gezeigt. Die Bedieneinrichtung 8 umfasst eine Bedienelementaufnahme 9, die in einer Aussparung 10 in der Kochfeldplatte 2 angeordnet ist. Die Bedienelementaufnahme 9 weist eine Vertiefung 11 auf, die zur Aufnahme eines Bedienelements 12 vorgesehen ist. Das Bedienelement 12 ist im Ausführungsbeispiel scheibenförmig bzw. diskusförmig ausgestaltet. Das Bedienelement 12 ist darüber hinaus zerstörungsfrei reversibel aus der Vertiefung 11 entnehmbar und wieder einsetzbar. Im in der Vertiefung 11 positionierten Zustand ist das Bedienelement 12 relativ zur Bedienelementaufnahme 9 bewegbar, wobei abhängig von der jeweiligen Relativposition eine Betriebsbedingungseinstellung des Kochfelds 1 möglich ist. In der Ausführung gemäß Fig. 2 ist vorgesehen, dass die Vertiefung 11 durch eine Begrenzungskontur 13 begrenzt ist. Diese umfasst einen Boden 14 und eine seitliche Wand 15. Wie zu erkennen ist, ist die seitliche Wand 15 von unten zu einer Oberseite 16 der Bedienelementaufnahme 9 hin betrachtet sich aufweitend und somit schräg nach außen gestellt ausgebildet. Die seitliche Wand 15 geht kantenfrei und somit auch mit einer gewissen Krümmung in den Boden 14 über. Der Boden 14 ist uneben ausgebildet und als kuppelartige Erhebung realisiert. Diese kuppelartige Erhebung weist einen zentralen, eben ausgebildeten Flächenbereich 17 auf, der in x-Richtung einen Durchmesser von etwa 10 mm aufweist und eine Kreisfläche darstellt. Seitlich anschließend an diesen zentralen Flächenbereich 12 ist ein schräg nach unten abfallender Flächenbereich 18 ausgebildet, der als Ringfläche gestaltet ist. Im Querschnitt bildet sich die kuppelartige Erhebung somit als Trapez aus, sodass sich im dreidimensionalen Gebilde eine Kegelstumpfform ergibt.

Es ist zu erkennen, dass die Vertiefung 11 mit ihren horizontalen Ausmaßen und somit in x-Richtung so dimensioniert ist, dass zwischen einer Seitenwand 19 bzw. einer Mantelwand des Bedienelements 12 und der seitlichen Wand 15 der Vertiefung 11 ein gewisses Spiel und somit ein Luftraum ausgebildet ist.

In Fig. 2 ist das Bedienelement 12 in einer Grundposition in der Vertiefung 11 gezeigt. Es ist dabei mittels magnetischer Haltekräfte gehalten. Dazu ist in der kuppelartigen Erhebung, insbesondere in zentraler Position, ein Haltemagnet 20 angeordnet, der in Wechselwirkung mit einem bedienelementseitigen Haltemagneten 21 ist. Wird das Bedienelement 12 somit aus seiner Grundstellung gekippt, so kann abhängig von der Kipprichtung eine der Kochzonen 4 bis 7 ausgewählt werden. Wird das Bedienelement 12 beispielsweise in eine 8-Uhr-Stellung gekippt, so wird die Kochzone 4 ausgewählt.

Dabei sind nicht gezeigte Sensoren vorhanden, die diese Kippstellung des Bedienelements 12 detektieren. Beispielsweise kann dies durch Hall-Sensoren erfolgen. Eine derartige Auswahl einer Kochzone 4 bis 7 kann dann auch noch optisch bestätigt werden. Dazu sind in der Bedienelementaufnahme 9 Anzeigebereiche 22 ausgebildet, die ein derartiges optisches Anzeigen der Auswahl der Kochzonen 4 bis 7 ermöglichen. Dies können Lichtquellen oder anderweitig ausgestaltete Symbole sein, die dann wiederum optisch hinterleuchtbar sind.

Aufgrund der Ausgestaltung des Bodens 14 und der im Ausführungsbeispiel ebenen Ausgestaltung des Bodens 23 des Bedienelements 12 ist diese Verkippung sehr einfach gewährleistet. Durch die Magnete 20 und 21 wird beim Loslassen der verkippten Stellung des Bedienelement 12 automatisch wieder in die in Fig. 2 gezeigte Grundstellung zurückbewegt. Nach einer Auswahl einer Kochzone 4 bis 7 kann dann durch Drehen des Bedienelements 12 um seine Längsachse A die gewünschte Kochstufe der ausgewählten Kochzone 4 bis 7 wertmäßig eingestellt werden.

In Fig. 3 ist in einer weiteren Schnittdarstellung in der x-y-Ebene ein weiteres Ausführungsbeispiel einer Bedieneinrichtung 8 gezeigt. Im Unterschied zur Ausgestaltung in Fig. 2 ist hier vorgesehen, dass unter der Bedienelementaufnahme 9 eine Lichtquelle 24 angeordnet ist. Diese emittiert Licht in Richtung des Bedienelements 12 durch einen lichtdurchlässigen Bereich der Bedienelementaufnahme 9. Das Licht dieser Lichtquelle 24 wird dann über den Boden 23 des Bedienelements 12 eingekoppelt und dort in einen Lichtleiter 25 eingekoppelt. Über diesen wird das Licht dann an eine andere Stelle des Bodens 14 geleitet, wo dann ein Lichtaustrittsbereich 26 ausgebildet ist. Von diesem wird dann das Licht aus dem Bedienelement 12 schräg nach außen und zum Boden 14 hin ausgekoppelt. Der Boden 14 ist zumindest bereichsweise, insbesondere in diesem Randbereich, zu der seitlichen Wand 15 hin definiert reflektierend ausgebildet. Wie dabei zu erkennen ist, wird dann das Licht von dem Boden 14 in den Freiraum 27 zwischen dem Bedienelement 12 und der Wand 15 nach oben und aus der Bedienelementaufnahme 9 herausgestrahlt.

Der Lichtaustrittsbereich kann diesbezüglich ein diskreter lokaler Bereich sein. Er kann jedoch auch ringförmig umlaufend am Boden 23 ausgebildet sein.

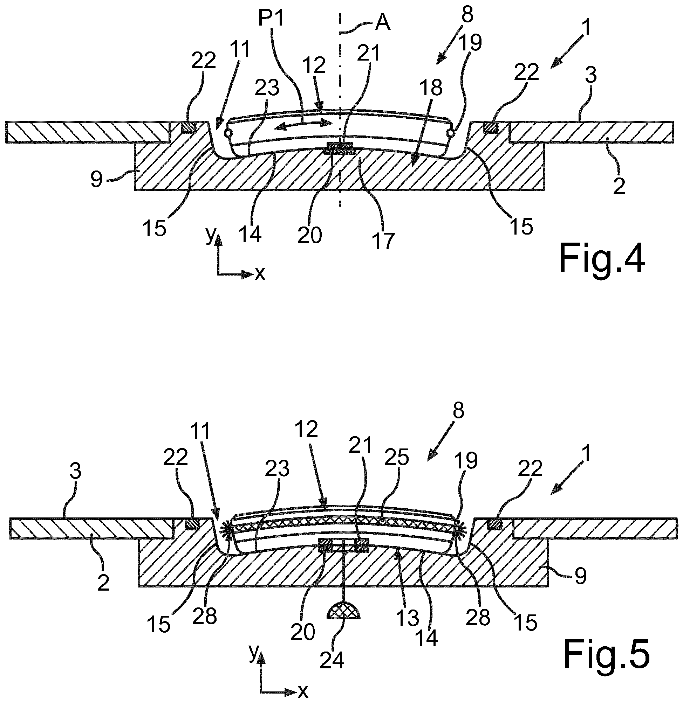

In Fig. 4 ist in einer weiteren Schnittdarstellung in der Ebene x-y ein Ausführungsbeispiel einer Bedieneinrichtung 8 gezeigt. Hier ist vorgesehen, dass der Boden 14 nicht mit einem ebenen zentralen Flächenbereich 17 ausgebildet ist, sondern über seine gesamte kuppelartige Erhebung eine stetige Krümmung aufweist. Des Weiteren ist hier vorgesehen, dass der Boden 23 des Bedienelements 12 ebenfalls eine derartige stetige Krümmung aufweist, die komplementär zur Krümmung des Bodens 14 der Vertiefung 11 ausgestaltet ist. Dadurch liegt der Boden 23 des Bedienelements 12 im Wesentlichen vollflächig auf dem Boden 14 der Vertiefung 13 auf. Das Bedienelement 12 kann somit entlang des bogenförmigen Pfeils P1 hin- und hergeschoben werden, wobei es diesbezüglich in der Vertiefung 11 quasi dreidimensional verschiebbar ist.

Vorzugsweise ist der Boden 23 zusätzlich auch mit einer noppenartigen Struktur versehen, so dass die Auflagefläche auf dem Boden 14 verkleinert ist, und somit die Reibung verringert wird, wodurch die Leichtgängigkeit der Bewegungsführung des Bedienelements 12 erhöht ist.

In Fig. 5 ist in einer weiteren Schnittdarstellung in der x-y-Ebene ein weiteres Ausführungsbeispiel der Bedieneinrichtung 8 gezeigt, wobei hier im Unterschied zur Ausgestaltung gemäß Fig. 4 das Bedienelement 12 einen Lichtleiter 25 aufweist. Dieser ist so ausgestaltet, dass das Licht von der Lichtquelle 24 einkoppelbar ist und dann über die Seitenwand 19 des Bedienelements 12 auskoppelbar ist, wobei hier zumindest ein Lichtaustrittsbereich 28 ausgebildet ist. Das Licht wird dann an die seitliche Wand 15 der Vertiefung 11 abgestrahlt und von dort nach oben aus der Vertiefung 11 heraus abgestrahlt. Der Lichtaustrittsbereich 28 kann als umlaufender Ring ausgebildet sein.

### Bezugszeichenliste

- 1: Kochfeld
- 2: Kochfeldplatte
- 3: Oberseite
- 4, 5, 6, 7: Kochzonen
- 8: Bedieneinrichtung
- 9: Bedienelementaufnahme
- 10: Aussparung
- 11: Vertiefung
- 12: Bedienelement
- 13: Begrenzungskontur
- 14: Boden
- 15: seitliche Wand
- 16: Oberseite
- 17, 18: Flächenbereiche
- 19: Seitenwand
- 20,21: Haltemagnete
- 22: Anzeigebereiche
- 23: Boden
- 24: Lichtquelle
- 25: Lichtleiter
- 26: Lichtaustrittsbereich
- 27: Freiraum
- 28: Lichtaustrittsbereich
- A: Längsachse
- P1: Pfeil

## Patentansprüche

1. Bedieneinrichtung (8) für ein Haushaltsgerät (1), mit einer Bedienelementaufnahme (9), die eine Vertiefung (11) aufweist, und einem in der Vertiefung (11) positionierbaren und entnehmbaren Bedienelement (12), dessen Bewegbarkeit durch eine Begrenzungskontur (13) der Vertiefung (11) begrenzt ist, und welches abhängig von einer Bewegung zur Einstellung von Betriebsbedingungen des Haushaltsgeräts (1) ausgebildet ist, wobei die Begrenzungskontur (13) einen unebenen Boden (14) aufweist, der mit einer kuppelartigen Erhebung ausgebildet ist, **dadurch gekennzeichnet, dass** das Bedienelement (12) einen Boden (23) und einen Lichtaustrittsbereich (28) aufweist, aus dem Licht in Richtung des Bodens (14) und/oder einer seitlichen Wand (15) der Begrenzungskontur (13) der Vertiefung (11) emittierbar ist, wobei das Bedienelement (12) einen Lichtleiter (25) aufweist, der so ausgestaltet ist, dass Licht von einer Lichtquelle (24) über den Boden (23) einkoppelbar und dann über eine Seitenwand (19) des Bedienelements (12) durch den hier ausgebildeten Lichtaustrittsbereich (28) auskoppelbar ist, um das Licht an die seitliche Wand (15) der Vertiefung (11) abzustrahlen und von dort nach oben aus der Vertiefung (11) heraus abzustrahlen.

2. Bedieneinrichtung (8) nach Anspruch 1, **dadurch gekennzeichnet, dass** die Vertiefung (11) mit einer horizontalen Breite ausgebildet ist, derart, dass das Bedienelement (12) im in der Vertiefung (11) positionierten Zustand mit horizontalem Spiel darin angeordnet ist.

3. Bedieneinrichtung (8) nach Anspruch 2, **dadurch gekennzeichnet, dass** die Vertiefung (11) mit ihrer Begrenzungskontur (13) so gestaltet ist, dass das Bedienelement (12) im in der Vertiefung (11) positionierten Zustand eine durch den Boden (14) begrenzte Kippbewegung durchführen kann.

4. Bedieneinrichtung (8) nach einem der vorhergehenden Ansprüche, **dadurch gekennzeichnet, dass** die Unebenheit des Bodens (14) in seinen Ausmaßen zumindest so groß wie die Ausmaße des Bodens (23) des Bedienelements (12) ausgebildet ist.

5. Bedieneinrichtung (8) nach einem der vorhergehenden Ansprüche, **dadurch gekennzeichnet, dass** die kuppelartige Erhebung einen zentralen ebenen Flächenbereich (17) aufweist, an den ein seitlich schräg nach außen abfallender Flächenbereich (18) anschließt.

6. Bedieneinrichtung (8) nach Anspruch 5, **dadurch gekennzeichnet, dass** der zentrale Flächenbereich (17) eine Kreisfläche ist.

7. Bedieneinrichtung (8) nach einem der Ansprüche 1 bis 4, **dadurch gekennzeichnet, dass** die kuppelartige Erhebung stetig gekrümmt ausgebildet ist.

8. Bedieneinrichtung (8) nach einem der vorhergehenden Ansprüche, **dadurch gekennzeichnet, dass** ein Boden (23) des Bedienelements (12) uneben, insbesondere an die Formgebung der kuppelartigen Erhebung angepasst ist.

9. Bedieneinrichtung (8) nach Anspruch 8, **dadurch gekennzeichnet, dass** der Boden (23) des Bedienelements (12) vollflächig auf dem Boden (14) der Vertiefung (11) aufsitzt.

10. Bedieneinrichtung (8) nach einem der vorhergehenden Ansprüche, **dadurch gekennzeichnet, dass** der Boden (14) der Vertiefung (11) zumindest bereichsweise zur Lichtreflexion in einen Freiraum (27) zwischen dem Bedienelement (12) und einer seitlichen Wand (15) der Begrenzungskontur (13) ausgebildet ist.

11. Bedieneinrichtung (8) nach einem der vorhergehenden Ansprüche, **dadurch gekennzeichnet, dass** eine Bedienelementexterne Lichtquelle (24) ausgebildet ist, deren Licht über den Boden (14) der Vertiefung (11) und über den Boden (23) des Bedienelements (12) in einen Lichtleiter (25) des Bedienelements (12) einkoppelbar ist.

12. Bedieneinrichtung (8) nach einem der vorhergehenden Ansprüche, **dadurch gekennzeichnet, dass** die Vertiefung (11) an der höchsten Stelle der Erhebung mit einer Tiefe ausgebildet ist, die zumindest der Hälfte, insbesondere zumindest zwei Drittel der Höhe des Bedienelements (12) entspricht.

13. Haushaltsgerät (1) mit einer Bedieneinrichtung (8) nach einem der vorhergehenden Ansprüche.

14. Haushaltsgerät nach Anspruch 13, welches als Kochfeld (1) ausgebildet ist, und bei welchem die Bedienelementaufnahme (9) als Einsatz in eine Aussparung (10) der Kochfeldplatte (2) ausgebildet ist.

## Claims

1. Operating device (8) for a domestic appliance (1), with an operating element receptacle (9), which has a recess (11), and an operating element (12) which can be positioned in and removed from the recess (11), the capacity for movement of which is delimited by a delimiting contour (13) of the recess (11), and which is embodied as a function of a movement for setting operating conditions of the domestic appliance (1), wherein the delimiting contour (13) has an uneven base (14), which is embodied with a domed elevation, **characterised in that** the operating element (12) has a base (23) and a light emission region (28), from which light can be emitted in the direction of the base (14) and/or a lateral wall (15) of the delimiting contour (13) of the recess (11), wherein the operating element (12) has a light guide (25), which is designed such that light can be coupled in from a light source (24) via the base (23) and can then be coupled out via a lateral wall (19) of the operating element (12) through the light emission region (28) embodied here, in order to radiate the light on the lateral wall (15) of the recess (11) and, from there, to radiate it upward out of the recess (11).

2. Operating device (8) according to claim 1, **characterised in that** the recess (11) is embodied with a horizontal width, such that the operating element (12), in the state in which it is positioned in the recess (11), is arranged therein with horizontal play.

3. Operating device (8) according to claim 2, **characterised in that** the delimiting contour (13) of the recess (11) is shaped such that the operating element (12), in the state in which it is positioned in the recess (11), can perform a tilting motion delimited by the base (14).

4. Operating device (8) according to one of the preceding claims, **characterised in that** the unevenness of the dimensions of the base (14) is embodied so as to be at least as large as the dimensions of the base (23) of the operating element (12).

5. Operating device (8) according to one of the preceding claims, **characterised in that** the domed elevation has a central, even surface area (17), to which a surface area (18) falling in a laterally oblique manner outwardly connects.

6. Operating device (8) according to claim 5, **characterised in that** the central surface area (17) is a circular surface.

7. Operating device (8) according to one of claims 1 to 4, **characterised in that** the domed elevation is embodied so as to be steadily arched.

8. Operating device (8) according to one of the preceding claims, **characterised in that** a base (23) of the operating element (12) is uneven, in particular adapted to the contouring of the domed elevation.

9. Operating device (8) according to claim 8, **characterised in that** the base (23) of the operating element (12) is fully seated on the base (14) of the recess (11).

10. Operating device (8) according to one of the preceding claims, **characterised in that** the base (14) of the recess (11) is embodied, at least in sections, so as to reflect light into an open space (27) between the operating element (12) and a lateral wall (15) of the delimiting contour (13).

11. Operating device (8) according to one of the preceding claims, **characterised in that** a light source external to the operating element is embodied, the light of which light source (24) can be coupled in via the base (14) of the recess (11) and via the base (23) of the operating element (12) into a light guide (25) of the operating element (12).

12. Operating device (8) according to one of the preceding claims, **characterised in that** the recess (11) is embodied at the highest point of the elevation with a depth which corresponds to at least half, in particular at least two thirds of the height of the operating element (12).

13. Domestic appliance (1) with an operating device (8) according to one of the preceding claims.

14. Domestic appliance according to claim 13, which is embodied as a hob (1), and in which the operating element receptacle (9) is embodied as an insert into a notch (10) in the hob plate (2).

## Revendications

1. Dispositif de commande (8) pour un appareil ménager (1), comprenant un logement d'élément de commande (9) qui présente un approfondissement (11), et comprenant un élément de commande (12) amovible et positionnable dans l'approfondissement (11), dont la mobilité est limitée par un contour de limitation (13) de l'approfondissement (11), et lequel est réalisé en fonction d'un mouvement de réglage de conditions de fonctionnement de l'appareil ménager (1), le contour de limitation (13) présentant un fond (14) inégal qui est réalisé avec une élévation en forme de coupole, **caractérisé en ce que** l'élément de commande (12) présente un fond (23) et une zone de sortie de lumière (28), hors de laquelle la lumière peut être émise en direction du fond (14) et/ou d'une paroi latérale (15) du contour de limitation (13) de l'approfondissement (11), l'élément de commande (12) présentant une fibre optique (25) qui est conçue de manière à ce que la lumière d'une source de lumière (24) puisse être couplée au-dessus du sol (23) et être ensuite, par l'intermédiaire d'une paroi latérale (19) de l'élément de commande (12), découplée à travers la zone de sortie de lumière (28) réalisée ici afin d'émettre la lumière sur la paroi latérale (15) de l'approfondissement (11) et de là pour l'émettre vers le haut en sortant de l'approfondissement (11).

2. Dispositif de commande (8) selon la revendication 1, **caractérisé en ce que** l'approfondissement (11) est réalisé avec une largeur horizontale de manière à ce que l'élément de commande (12), à l'état positionné dans l'approfondissement (11), soit disposé dedans avec un jeu horizontal.

3. Dispositif de commande (8) selon la revendication 2, **caractérisé en ce que** l'approfondissement (11), avec son contour de limitation (13), est conçu de manière à ce que l'élément de commande (12), à l'état positionné dans l'approfondissement (11), puisse réaliser un mouvement de bascule limité par le fond (14).

4. Dispositif de commande (8) selon l'une quelconque des revendications précédentes, **caractérisé en ce que** l'inégalité du fond (14), dans ses dimensions, est réalisée de manière au moins aussi grande que les dimensions du fond (23) de l'élément de commande (12).

5. Dispositif de commande (8) selon l'une quelconque des revendications précédentes, **caractérisé en ce que** l'élévation en forme de coupole présente une zone de surface (17) centrale plane à laquelle se raccorde une zone de surface (18) descendant latéralement de manière oblique vers l'extérieur.

6. Dispositif de commande (8) selon la revendication 5, **caractérisé en ce que** la zone de surface (17) centrale est une surface circulaire.

7. Dispositif de commande (8) selon l'une quelconque des revendications 1 à 4, **caractérisé en ce que** l'élévation en forme de coupole est réalisée de manière continuellement courbée.

8. Dispositif de commande (8) selon l'une quelconque des revendications précédentes, **caractérisé en ce qu'**un fond (23) de l'élément de commande (12) est adapté de manière inégale, notamment à la forme de l'élévation en forme de coupole.

9. Dispositif de commande (8) selon la revendication 8, **caractérisé en ce que** le fond (23) de l'élément de commande (12) repose sur toute sa surface sur le fond (14) de l'approfondissement (11).

10. Dispositif de commande (8) selon l'une quelconque des revendications précédentes, **caractérisé en ce que** le fond (14) de l'approfondissement (11) est réalisé au moins en partie pour réfléchir la lumière dans un espace libre (27) entre l'élément de commande (12) et une paroi latérale (15) du contour de limitation (13).

11. Dispositif de commande (8) selon l'une quelconque des revendications précédentes, **caractérisé en ce qu'**une source de lumière (24) externe à l'élément de commande est réalisée, dont la lumière peut être injectée dans une fibre optique (25) de l"élément de commande (12) au-dessus du fond (14) de l'approfondissement (11) et au-dessus du fond (23) de l'élément de commande (12).

12. Dispositif de commande (8) selon l'une quelconque des revendications précédentes, **caractérisé en ce que** l'approfondissement (11) est réalisé à l'endroit le plus élevé de l'élévation avec une profondeur qui correspond au moins à la moitié, notamment au moins à deux tiers de la hauteur de l'élément de commande (12).

13. Appareil ménager (1) comprenant un dispositif de commande (8) selon l'une quelconque des revendications précédentes.

14. Appareil ménager selon la revendication 13, lequel est réalisé comme plaque de cuisson (1) et dans lequel le logement d'élément de commande (9) est réalisé comme insert dans un évidement (10) de la table de cuisson (2).
